# EUROPEAN PATENT SPECIFICATION

(11) **EP 4 238 148 B1**
(45) Date of publication and mention of the grant of the patent: **28.01.2026**
(21) Application number: 21798147.1
(22) Date of filing: 26.10.2021
(51) Int. Cl.: H10N 30/87, H10N 30/06

(54) **LARGE-AREA PRINTED PIEZOELECTRICS WITH HIGH FREQUENCY RESPONSE**
GROSSFLÄCHIGE GEDRUCKTE PIEZOELEKTRIK MIT HOHER FREQUENZANTWORT
PIÉZOÉLECTRIQUES IMPRIMÉES À GRANDE SURFACE AVEC HAUTE RÉPONSE DE FREQUENCE

(30) Priority: 27.10.2020 EP 20204030
(43) Date of publication of application: 06.09.2023
(73) Proprietor: Nederlandse Organisatie voor toegepast- natuurwetenschappelijk onderzoek TNO, 2595 DA 's-Gravenhage (NL)
(72) Inventor: ZALAR, Peter, 2595 DA 's-Gravenhage (NL); SMITS, Edsger Constant Pieter, 2595 DA 's-Gravenhage (NL); BURGHOORN, Maria Mathea Antonetta, 2595 DA 's-Gravenhage (NL); RAITERI, Daniele, 2595 DA 's-Gravenhage (NL)
(74) Representative: V.O.
(86) International application number: PCT/NL2021/050649
(87) International publication number: WO 2022/093017

(56) References cited:
- WO-A1-02/43071
- WO-A1-2005/086528
- KR-B1- 100 728 900
- US-A- 4 786 837

## Description

### TECHNICAL FIELD AND BACKGROUND

The present disclosure relates to piezoelectric devices and methods of manufacturing.

Piezoelectric devices are used in various applications. Some applications, such as sensing and actuation, can benefit from relatively large sensor areas, e.g. similar in size to the target surface. In the typical formation of a piezoelectric device, a piezoelectric layer is sandwiched between two electrodes. Device failure is usually evident during the poling of piezoelectric devices. Poling orients ferroelectric crystalline domains by the application of an electric field greater than the coercive field. The coercive electrical fields for fully poling a ferroelectric material are typically on the order of 100 MV/m for ferroelectric polymers. To optimally obtain large-area devices the piezoelectric layer is preferably free of defects and uniform in thickness and remain so during all processing steps. For example, defects can result in shorts or leakage. So, for the process of poling, homogeneous application of electrical fields over a defect free layer is needed to uniformly polarize the ferroelectric layer. Satisfying these conditions can be difficult, especially on substrates and electrodes that have high surface roughness (rms roughness, ≥ 1 pm) or low surface energies (<1000 mJ/m).

Piezoelectric devices according to the preamble of independent claim 1 are known from WO 2005/086528 A1, US 4,786,837 or KR 10-0728900 B1, for example.

There remains a need to scale the device area of thin film (e.g. <50 pm) piezoelectric devices to larger areas, e.g. more than one square centimeter, with high yield and preserving the frequency response of the piezoelectric, e.g. >200 kHz for some applications.

### SUMMARY

The present invention provides a piezoelectric device according to independent claim 1 and a method of manufacturing according to independent claim 15. Further advantageous features are set out in the dependent claims.

A polymer electrode can be relatively smooth and have relatively high surface energies, e.g. facilitating the formation of a defect-free film. So, the problem of yield can be alleviated by using polymer electrodes. The conductive line structure can be used to help alleviate the relatively poor conductivity of the polymer based conductive material, e.g. high sheet resistance. This can improve a frequency response cutoff frequency (RC time) of the piezoelectric device. It can also help to homogeneously deliver voltage during (contact) poling of the piezoelectric device and/or prevent short circuits. The present disclosure thus provides various design options which enable the production of large-area piezoelectric sensors with high yield. In these designs, the frequency response of piezoelectric devices can be extended as compared to those employing conventional device structures (simple sandwich consisting of electrode/piezoelectric/electrode) which are typically used in device designs where the piezoelectric layer is small.

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A,2A,3A,4A illustrate cross-section views of respective piezoelectric devices;
FIGs 1B,2B,3B,4B illustrate corresponding top views of select layers forming part of the respective devices;
FIGs 5A-5C illustrate cross-section views of further piezoelectric devices;
FIGs 6A,6B illustrate a grid of lines connected to a busbar via a fuse structure.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

As described herein, the issues of yield, poling quality, and frequency response can be alleviated by one or more of a conducting busbar (e.g. Ag, Au, C, etc.) around the polymer electrode, e.g. PEDOT:PSS or polyaniline, to ensure more homogeneous electric poling fields; a dielectric barrier on top of the piezoelectric layer, e.g. above of the conducting busbar to prevent electrical shorts during poling; a conducting grid (e.g. Ag, Au, C, etc.) preferably printed on top the polymer electrode layer, most preferably featuring an additional dielectric print atop the grid; and segmentation strategy that avoids critical device failure by a behavior analogous to a fuse.

Polymer electrodes typically have sheet resistances which are normally too high for large-area devices (e.g. >200 Q/sq), prohibiting their use as standalone electrodes. It is even possible that on different substrates (such as thermoplastic polyurethane), the sheet resistance can be higher than advertised, worsening the frequency response. A polymer electrode with such poor conductivity compared to a metal electrode can result in longer response time, especially for a large area piezo electric layer. For example, the frequency response can be understood from the characteristic RC time which describes the time constant of the change in voltage across a capacitor in time. So the relatively low conductivity of a polymer based conductive material typically makes this material unsuitable for large area piezoelectric devices which require a high frequency response. By using a busbar or metal grid structure, e.g. formed by printed conductors (e.g. Ag, Au, C, etc.), the intrinsic frequency response of the piezoelectric device can be largely preserved.

For various applications of piezoelectric devices, the cutoff frequency is an important device parameter, e.g. for speakers and other acoustic transducers/actuators (e.g. ultrasonic devices). To negate the influence of the polymer electrode's sheet resistance, a conducting ring (busbar) can be overprinted with PEDOT:PSS. The busbar enables larger sensor areas since a more homogeneous distribution of the electric field during poling is achieved. The busbar can also connected to the routing, which connects the sensor to a larger integrated product and/or a connector. On the overlapping areas of busbar with top electrode and/or routing, there is an increased risk of shorts during poling at high electric fields (> 60 V/µm) due to locally thinner piezo material. The risk of shorts can be minimized by a dielectric barrier, which e.g. ensures sufficient distance between the conducting busbar and the top electrode. The dielectric barrier can be applied on top of, or underneath the piezo material.

Other or further advantages can be achieved by a segmentation strategy that avoids critical device failure by a behavior analogous to a fuse. One of the electrode layers consists of segmented areas with fuses. Once a short in one segmented area occurs during the poling process, the resulting high current will burn the narrow line (fuse) which connects this area to a busbar. This area will be dysfunctional, but the rest of the piezoelectric sensor area still works. This structure can use aspects of the designs described above (dielectric bridges).

By the present teachings, large sensor areas are possible while preserving the device's frequency response. The design enables improvement of device yield, even on uneven substrates (such as thermoplastic polyurethanes). The design can be a fully printable, and thus upscalable, design. The design can be antifragile, e.g. it can survive even if some parts fail. The design has the possibility of an optically transparent active sensor/actuator, when polymeric electrodes are used in the top and bottom electrode.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

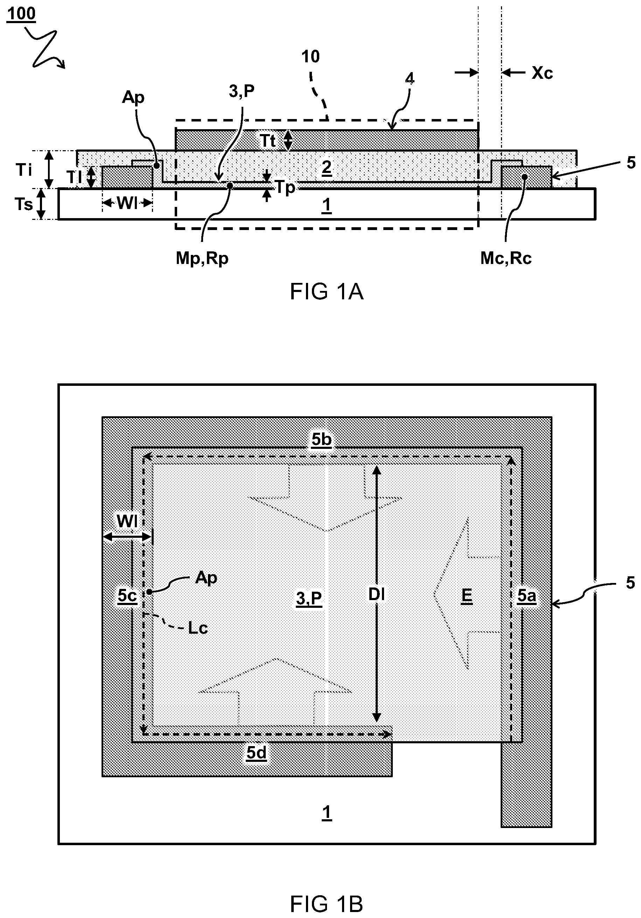

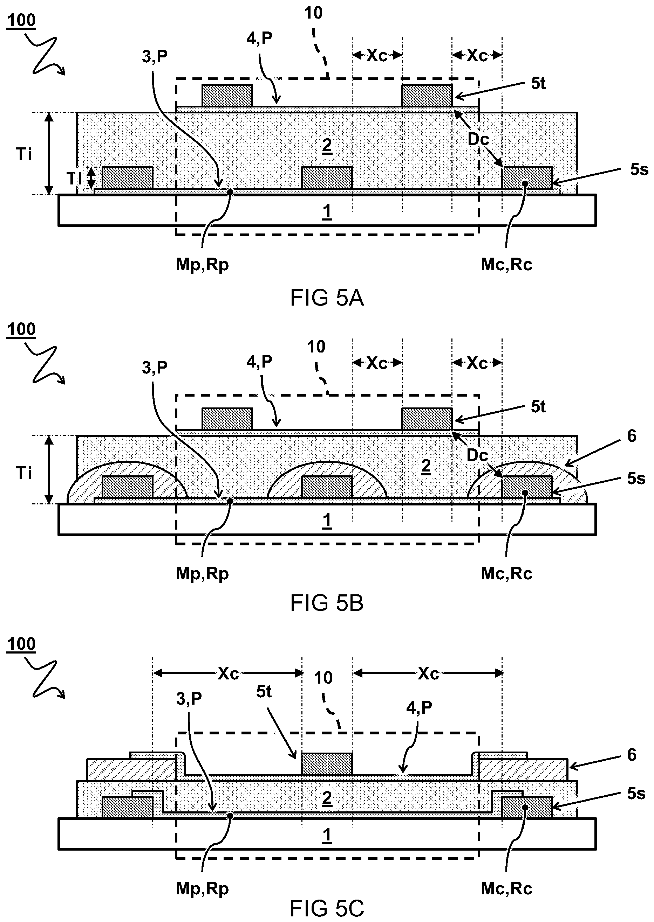

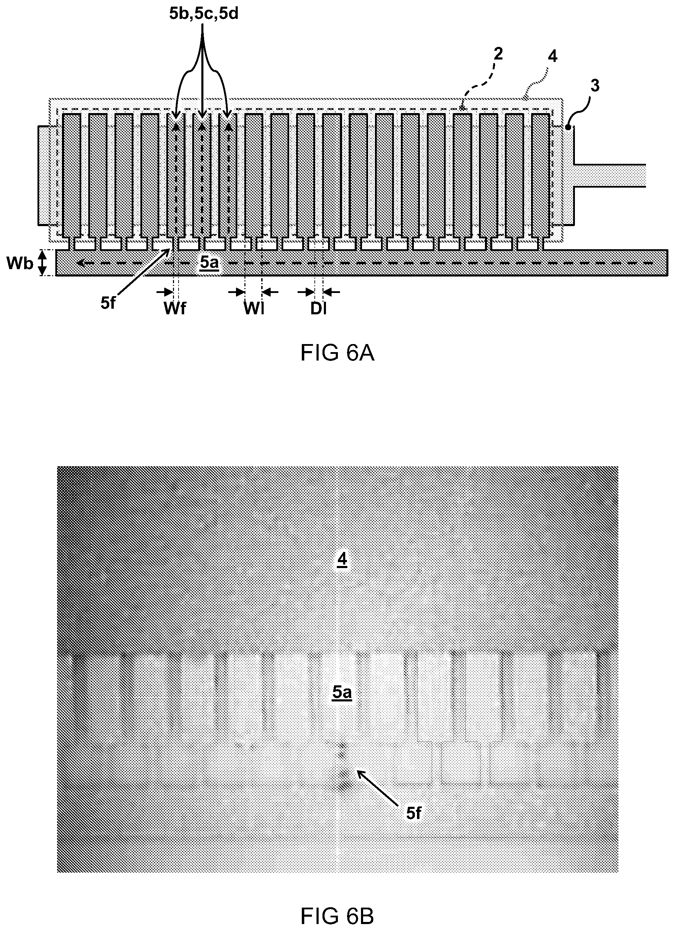

FIG 1A,2A,3A,4A illustrate cross-section views of respective piezoelectric devices 100; FIGs 1B,2B,3B,4B illustrate corresponding top views of select layers forming part of the respective devices; FIGs 5A-5C illustrate cross-section views of further piezoelectric devices 100; FIGs 6A,6B illustrate a grid of lines connected to a busbar via a fuse structure. Each of the figures illustrates a piezoelectric device 100 comprising a piezoelectric stack, preferably disposed on a substrate 1. The piezoelectric stack comprises a piezoelectric layer 2 sandwiched between a bottom electrode 3 and a top electrode 4 to form a piezoelectric transducer 10.

At least one of the bottom and top electrodes 3,4 is a polymer electrode "P" formed of a polymer based conductive material "Mp" having a first resistivity "Rp". In one embodiment, the device comprises a conductive line structure 5 forming an extended line contact "Lc" with contact areas "Ap" of the polymer electrode "P" along a respective length of one or more conductive lines 5a,5b,5c,5d of the conductive line structure 5 at least partially overlapping the contact areas "Ap". The conductive line structure 5 is formed of a conductive material Mc having a second resistivity "Rc" that is lower than the first resistivity "Rp" to help distribute an electrical field "E" or voltage over the polymer electrode "P" via the extended line contact "Lc".

Typically, the polymer based conductive material "Mp" has a relatively high resistivity, i.e. low (electrical) conductivity. Preferably, the polymer based conductive material "Mp" comprises poly(3,4-ethylenedioxythiophene) polystyrene sulfonate better known as "PEDOT:PSS". Also other polymer based conductive materials can be envisaged, such as polyaniline. A polymer based conductive material "Mp" such as PEDOT:PSS has a typical resistivity between 500-5000 Ω.cm, depending on the composition This may be compared to a metal conductor such as copper having a typical resistivity around 10⁻⁶ Ω.cm. In a preferred embodiment, the second resistivity "Rc" is much lower than the first resistivity "Rp". e.g. by at least a factor ten, at least a factor hundred, at least a factor thousand, at least a factor ten thousand, at least a factor hundred thousand, or more.

Typically, the polymer electrode "P" has a relatively high sheet resistance of more than hundred ohms per square ("Ω/sq"), or even >200 Ω/sq. For example, for screen printable pastes the typical sheet resistivity is between 200 - 500 Ω/sq. This can be compared to a low resistance metal electrode such as copper which typically has a sheet resistance around 0.5 mΩ/sq. In a preferred embodiment, the conductive line structure 5 has a sheet resistance much lower than that of the polymer electrode "P", e.g. by at least a factor ten, at least a factor hundred, at least a factor thousand, at least a factor ten thousand, at least a factor hundred thousand, or more. The lower the (sheet) resistance of the conductive line structure 5, the better this structure can act to distribute the electric field and/or voltage over the polymer electrode "P" at a fast rate. It can also decrease the characteristic RC time of the device.

As described herein, a conductive line, e.g. circuit lane or electrode line, is understood as an elongate structure with a length that is significantly higher than its width, e.g. by at least a factor five, ten, twenty, or more. The line thickness "Tl" is typically similar, the same, or less than the line width. Typically, each conductive line has a line width "Wl" less than one millimeter, less than five hundred micrometer, less than two hundred micrometer, or less than hundred micrometer, e.g. between one and fifty micrometer, or between five and thirty micrometer. For example, the conductive lines have a thickness "Tl" between one and fifty micrometer, preferably between five and ten micrometer. Of course the thickness can vary, e.g. depending on the conductivity of the material.

Preferably, there is at least some distance between adjacent lines, In some embodiments, e.g. as shown in FIGs 1-4, the line-to-line distance "Dl" can be much higher than the line width, e.g. more than a factor two, three, five, ten or more. By keeping a larger distance between the conductive lines, the structure may be more flexible and/or easier to manufacture. In other or further embodiments, e.g. as shown in FIGs 6A, the line-to-line distance "Dl" can be the same or smaller than the line width "Wl", e.g. between ten percent and hundred percent of the line width "Wl". By packing the conductive lines in close proximity to each other, even a poorly conductive polymer layer can be suitably addressed.

In a preferred embodiment, the conductive line structure 5 comprises an interconnected set of one or more conductive metal (or metalloid) lines, e.g. silver, gold, copper, carbon, et cetera. Most preferably, the conductive line structure 5 comprises a set of printed metal lines, e.g. lines of printed silver ink or other ink. For example, the metal structure is printed or otherwise applied onto the substrate 1 before depositing the polymer electrode "P" (as shown e.g. in FIGs 1A,2A,3A,4A) and/or on top of polymer electrode "P" (as shown e.g. in FIGs 5A-5C).

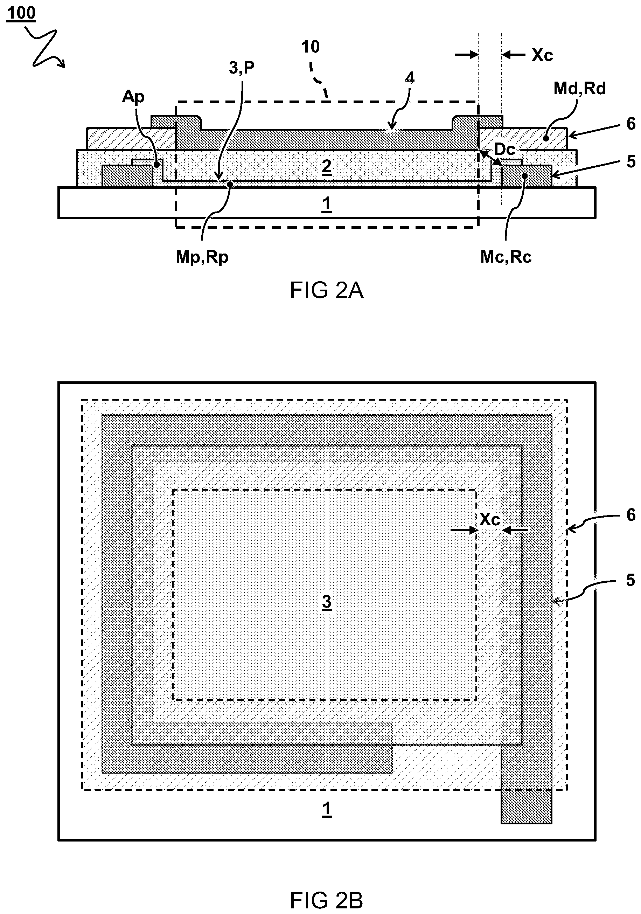

In embodiments according to the present invention, e.g. as illustrated in FIGs 1 and 2, the conductive line structure 5 comprises a busbar, e.g. conductive line, forming the extended contact by a length of the busbar extending at least partially around and contacting a circumference of the polymer electrode "P". For example, the busbar extends along at least thirty percent of the circumference, preferably at least fifty percent, more preferably at least eighty or ninety percent, or extending around the whole circumference. Alternatively, or additionally, the busbar extends to at least contact opposing edges of the circumference around the polymer electrode P. In other words, the polymer electrode "P" can form an island or peninsula surrounded on one or more sides by the busbar contacting the polymer based conductive material "Mp".

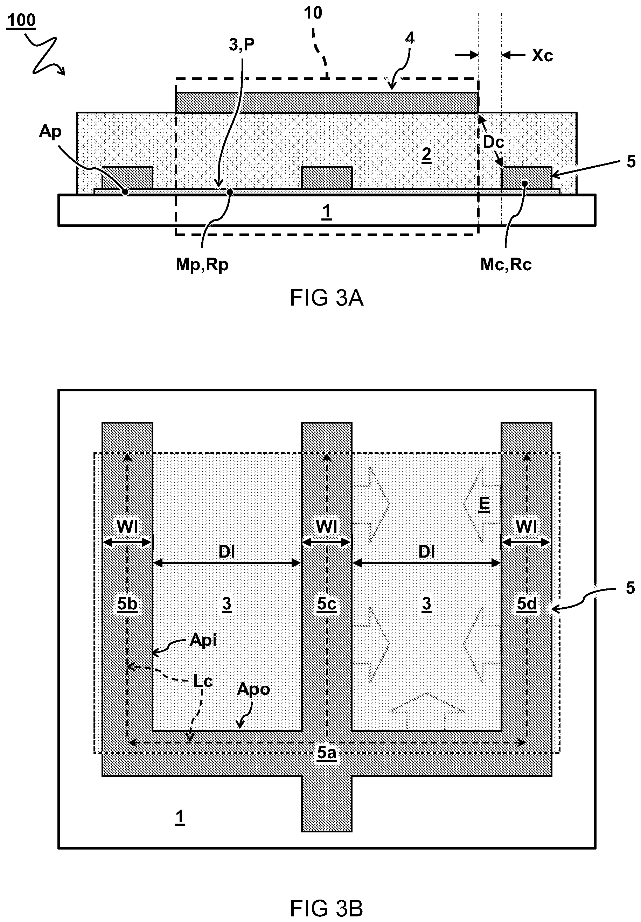

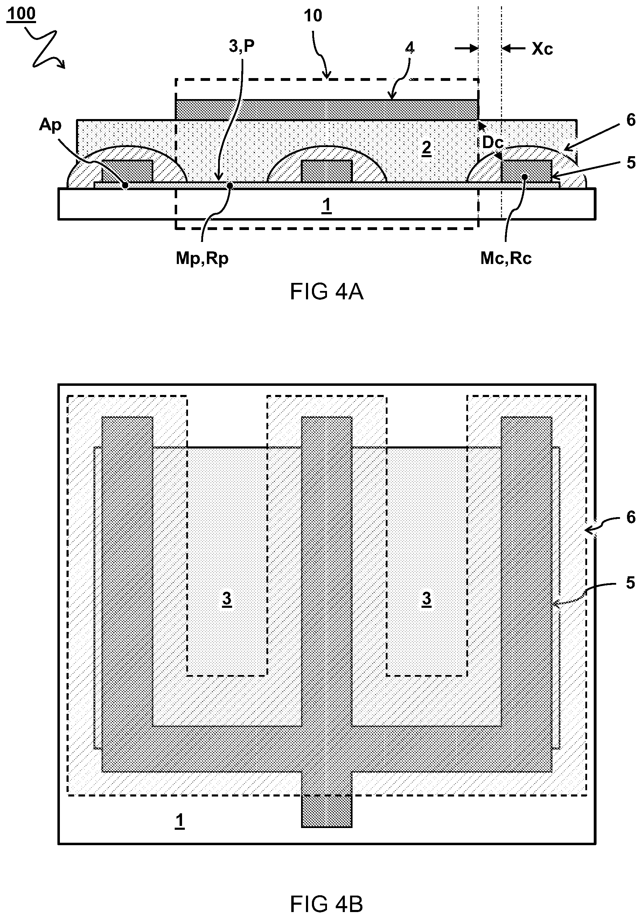

In other or further embodiments, e.g. as illustrated in FIGs 3 and 4, the conductive line structure 5 comprises a grid of conductive lines 5b,5c,5d covering and/or segmenting inner contact areas "Api" of the polymer electrode "P" and/or piezoelectric layer 2. The grid of conductive lines 5b,5c,5d is interconnected via a busbar. In one embodiment, e.g. as shown in FIG 3, a conductive line 5a forming the busbar covers outer contact areas at an edge of the polymer electrode "P". It will be noted that, in principle, the layer forming the polymer electrode "P" can be limited to an inner area within the circumference of the busbar, or form a larger area that continues beyond the busbar, e.g. to form multiple piezoelectric transducers, each with a respective busbar and/or grid of lines. In some embodiments, e.g. as shown in FIG 6, the conductive line 5a forming the busbar need not directly contact the polymer electrode "P". For example, the polymer electrode "P" can be exclusively contacted via the grid of lines.

As described herein, the piezoelectric device 100 comprises at least one polymer electrode, preferably with a layer thickness (Tp) between 100 - 500 nm, e.g. 200 nm; and a busbar and/or grid of metal lines, e.g. printed silver, with a line thickness between 5 - 10 µm printed onto or below the polymer electrode. Advantages of the polymer layer may include the possibility to make the polymer electrode transparent. Another or further advantage may be the increased yield / lower surface roughness for the subsequent deposition of a piezo layer compared to an electrode made entirely of metal, e.g. silver. Preferably, the piezoelectric layer 2 comprises a piezoelectric polymer material, such as P(VDF-TrFE), or a composite of polymer material with inorganic, e.g. piezoelectric, material.

Typically, the piezoelectric layer 2 has a layer thickness Ti between one and fifty micrometer, preferably between five and thirty micrometer. Typically, the piezoelectric device 100 also comprises top electrode, e.g. formed by a metal layer (e.g. the same as the busbar) with a layer thickness of e.g. 5 - 10 µm; or another conductive polymer layer (e.g. the same as the bottom electrode) with a respective conductive line structure 5 on top. For example, each of the top and bottom polymer electrode layers, and the piezoelectric layer can be transparent. The stack of layers is preferably disposed on a flexible substrate 1, e.g. having a typical substrate thickness Ts more than fifty micrometer, e.g. up to one or more millimeters thick.

As will be understood from the embodiments described and shown herein, the conductive line structure 5 may cover only part of the polymer electrode P, e.g. spreading the electric field "E" into other (adjacent) areas of the polymer electrode P there between, i.e. other areas of the polymer electrode P without (not being covered by) the conductive line structure 5, e.g. between and/or adjacent respective lines of the conductive line structure 5. Typically, a percentage of the polymer electrode P covered by the conductive line structure 5 is less than ninety percent, less than fifty percent, less than thirty percent, or even less than twenty percent, e.g. between five and ninety percent. For example, a surface area of the polymer electrode P is higher than the conductive line structure 5, e.g. by at least a factor 1.1 (ten percent), 1.2 (twenty percent), 1.5 (fifty percent), two, three, five, ten, twenty, or more.

As will be appreciated, the present teachings can provide particular benefit for piezoelectric devices with one or more polymer electrodes P having a relatively large surface area. For example, the polymer electrode "P" is formed by a layer having a thickness less than one micrometer, e.g. between 100 - 500 nm, and contacting the piezoelectric layer 2 over a surfaces area of at least one square centimeter, or more, e.g. at least two, five, or even ten square centimeter. For example, applications may include a sensor, actuator, and/or pushbutton comprising the piezoelectric device 100 as described herein, with optional backlighting through one or more transparent polymer electrodes.

In some embodiments, e.g. as shown in FIG 6, the grid of conductive lines 5b,5c,5d is interconnected via a structure described herein as 'fuse lines' 5f. In one embodiment, wherein the polymer electrode "P" is covered by a grid of conductive lines 5b,5c,5d having a first line width "Wl", wherein each line is connected to a busbar 5a via a fuse line 5f having a second line width Wf that is smaller than the first line width "Wl", e.g. by at least a factor two, three, or more.

Preferably, the conductive line 5a forming the busbar has a relatively large third line width Wb, e.g. the same as the first line width "Wl", or e.g. larger by at least ten, twenty, or thirty percent. As shown in FIG 6B, the relatively thin fuse line 5f can effectively act as a 'fuse' to cut a connection to a respective conductive line 5a (burn out) when the current to that line exceeds a current threshold. As will be appreciated, this can prevent a total failure of the device in case of (localized) short-circuit through the piezoelectric layer 2, e.g. during poling or regular use. While such fuse structure can have particular advantage in combination with a polymer electrode "P" to spread the electric field between the lines, in principle the polymer electrode "P" can also be omitted. For example, the grid of lines 5b,5c,5d, connected via respective fuses to a busbar, can directly contact the piezoelectric layer 2. For example, a distance between the lines can be relatively small, e.g. less than fifty percent of the line width, so the lines effectively cover most of the piezoelectric layer 2.

In some embodiments, e.g. as shown in FIGs 2, 4, and 5, the piezoelectric device 100 comprises a dielectric barrier 6 formed by a pattern of dielectric material "Md" disposed between the conductive line structure 5 on one side of the piezoelectric layer 2, and an opposing electrode on the other side of the piezoelectric layer 2. For example, the dielectric barrier 6 is formed of a dielectric material "Md" having a third resistivity Rd that is (much) higher than the first resistivity "Rp", e.g. by at least a factor two, three, five, ten, twenty, fifty, hundred, thousand, or more.

In some embodiments, e.g. as shown in FIGs 2A and 5C, a dielectric barrier 6 is disposed on top of the piezoelectric layer 2, wherein the pattern of dielectric material "Md" is disposed above the conductive line structure 5 with the piezoelectric layer 2 between the dielectric barrier 6 and the conductive line structure 5, to prevent any conductive material of the top electrode 4 to contact the piezoelectric layer 2 above the conductive line structure 5. For example, as shown in FIGs 2B and 4B, the dielectric barrier 6 is disposed on the piezoelectric layer 2 in a pattern matching that of the conductive line structure 5 (on the other side of the piezoelectric layer 2), optionally with some margin Xc, e.g. at least ten micrometer. Example of suitable materials for the dielectric barrier may include, e.g. , polymer material, such as polyurethane, or composite material, e.g. comprising inorganic fillers/polymer. By using the dielectric barrier 6 it can be ensured that the top electrode 4 exclusively contacts the piezoelectric layer 2 at positions that are laterally offset (with the margin Xc) with respect to a nearest line of the conductive line structure 5 below the piezoelectric layer 2. In this way, short-circuits between the conductive line structure 5 and opposing electrode can be prevented, in particular during poling.

In one embodiment, e.g. as shown in FIG 2A, the opposing (top) electrode can be formed of a conductive material that can have the same or similar high conductivity/low resistivity as the conductive line structure 5. For example, the conductive material of the top electrode 4 can be printed after depositing the dielectric barrier 6. In another or further embodiment, e.g. as shown in FIG 5C, the opposing (top) electrode can also be a polymer electrode "P" with a respective conductive line structure 5t. For example, the polymer based conductive material "Mp" can be deposited after the dielectric barrier 6, and the conductive line structure 5 on top of that (or below).

In some embodiments, e.g. as shown in FIG 4A and 5B, the dielectric barrier 6 is disposed between the conductive line structure 5 and the piezoelectric layer 2, wherein the conductive line structure 5 is disposed on top of the polymer electrode "P". In a preferred embodiment, the dielectric barrier 6 forms a rounded structure on top of the conductive line structure 5. This can help to provide a relatively smooth layer for depositing the piezoelectric layer 2.

In some embodiments, as shown e.g. in FIGs 5A-5C, the piezoelectric device 100 comprises polymer electrodes P both as the bottom electrode 3 and as the top electrode 4. For example, the bottom electrode 3 is provided with a first conductive line structure 5s and the top electrode 4 is provided with a second conductive line structure 5t, as described herein.

In a preferred embodiment, conductive lines forming the second conductive line structure 5t are staggered (distributed with lateral offset) with respect to conductive lines forming the first conductive line structure 5s, e.g. in a top view projection perpendicular to the substrate plane. By providing the conductive lines opposite the piezoelectric layer 2 in a staggered configuration, the distance "Dc" between nearest lines through the piezoelectric layer 2 can be maximized. This may e.g. prevent short circuits through the piezoelectric layer 2. Preferably, the line-to-line distance "Dc" through the piezoelectric layer 2 is higher than the layer thickness "Ti" of the piezoelectric layer 2 minus any height "Tl" of the bottom lines, e.g. Dc is more than (Ti-Tl) by at least a factor 1.1, 1.2, 1.3, or more. In one embodiment, a respective line of the first conductive line structure 5s is (e.g. equidistantly) disposed in between a respective pair lines of the second conductive line structure 5t and/or vice versa. In another or further embodiment, a set of lines forming the first conductive line structure 5s and a set of lines forming the second conductive line structure 5t are parallel to each other but laterally offset in a plane parallel to the substrate 1.

As illustrated e.g. in FIG 5B, the staggered formation can be combined with a dielectric barrier 6 disposed between the lines of the first conductive line structure 5s and second conductive line structure 5t. This can provide further protection against short circuits, e.g. allowing a lower thickness "Ti" of the piezoelectric layer 2. As illustrated e.g. in FIG 5C, a staggered line forming the second conductive line structure 5t can also be combined with a busbar forming the first conductive line structure 5s and/or with a dielectric barrier 6 delineating the top polymer electrode "P". Also other combinations are possible, e.g. combining busbars and/or grid lines with one or more fuse lines 5f as discussed with reference to FIG 6.

For the purpose of clarity and a concise description, features are described herein as part of the same or separate embodiments, however, it will be appreciated that the scope of the invention may include embodiments having combinations of all or some of the features described. For example, while embodiments were shown with various arrangements of polymer layers, busbars, grid lines, dielectric barriers, and fuse lines, also alternative ways may be envisaged by those skilled in the art having the benefit of the present disclosure for achieving a similar function and result. The various elements of the embodiments as discussed and shown offer certain advantages, such as providing large area piezoelectric devices with high yield and high frequency response. Of course, it is to be appreciated that any one of the above embodiments or processes may be combined with one or more other embodiments or processes to provide even further improvements in finding and matching designs and advantages. It is appreciated that this disclosure offers particular advantages to printed piezoelectric devices, and in general can be applied for any application of polymer electrodes and conductive line structures in piezoelectric devices.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A piezoelectric device (100) comprising
a piezoelectric stack with a piezoelectric layer (2) sandwiched between a bottom electrode (3) and a top electrode (4) to form a piezoelectric transducer (10), wherein at least one of the bottom and top electrodes (3,4) is a polymer electrode (P) formed of a polymer based conductive material (Mp) having a first resistivity (Rp); and
a conductive line structure (5) forming an extended line contact (Lc) with contact areas (Ap) of the polymer electrode (P) along a respective length of one or more conductive lines (5a,5b,5c,5d) of the conductive line structure (5) overlapping the contact areas (Ap), wherein the conductive line structure (5) is formed of a conductive material (Mc) having a second resistivity (Rc) that is lower than the first resistivity (Rp) to help distribute an electrical field (E) over the polymer electrode (P) via the extended line contact (Lc);
**characterised in that**
the conductive line structure (5) comprises a busbar forming the extended line contact (Lc) by a length of the busbar extending at least partially around and contacting a circumference on different sides of the polymer electrode (P).

2. The device according to the preceding claim, wherein the conductive line structure (5) overlapping the contact areas (Ap) comprises an interconnected set of conductive metal lines (5a,5b,5c,5d), each line having a line width (Wl) less than half of a millimeter.

3. The device according to any of the preceding claims, wherein the length of the busbar extends along at least fifty percent of the circumference of the polymer electrode (P).

4. The device according to any of the preceding claims, wherein the adjacent areas of the polymer electrode (P) between the conductive lines are not covered by the conductive line structure (5).

5. The device according to the preceding two claims, wherein the conductive line structure (5) comprises a grid of conductive lines (5b,5c,5d) covering inner contact areas (Api) of the polymer electrode (P), to help distribute the electrical field (E) into adjacent areas of the polymer electrode (P) including between the conductive lines, wherein the grid of conductive lines (5b,5c,5d) is interconnected via the busbar.

6. The device according to the preceding claim, wherein a conductive line (5a), forming the busbar, covers outer contact areas (Apo) at an edge of the polymer electrode (P).

7. The device according to any of the preceding claims, wherein the polymer electrode (P) is covered by a grid of conductive lines (5b,5c,5d) having a first line width (Wl), wherein each line is connected to the busbar (5a) via a fuse line (5f) having a second line width (Wf) that is smaller than the first line width (Wl) by at least a factor two.

8. The device according to any of the preceding claims, wherein the piezoelectric device (100) comprises a dielectric barrier (6) formed by a pattern of dielectric material (Md) disposed between the conductive line structure (5) on one side of the piezoelectric layer (2), and an opposing electrode on the other side of the piezoelectric layer (2).

9. The device according to the preceding claim, wherein the dielectric barrier (6) is disposed on top of the piezoelectric layer (2), wherein the pattern of dielectric material (Md) is disposed above the conductive line structure (5) with the piezoelectric layer (2) between the dielectric barrier (6) and the conductive line structure (5), to prevent any conductive material of the top electrode (4) to contact the piezoelectric layer (2) above the conductive line structure (5).

10. The device according to any of the two preceding claims, wherein the dielectric barrier (6) is disposed between the conductive line structure (5) and the piezoelectric layer (2), wherein the conductive line structure (5) is disposed on top of the polymer electrode (P).

11. The device according to any of the preceding claims, comprising polymer electrodes (P) both as the bottom electrode (3) and as the top electrode (4), wherein the bottom electrode (3) is provided with a first conductive line structure (5s) and the top electrode (4) is provided with a second conductive line structure (5t), wherein conductive lines forming the second conductive line structure (5t) are staggered with respect to conductive lines forming the first conductive line structure (5s).

12. The device according to any of the preceding claims, wherein the polymer electrode (P) is formed by a layer of polymer based conductive material (Mp) having a thickness of less than one micrometer contacting the piezoelectric layer (2) over a total surfaces area of at least two square centimeters.

13. The device according to any of the preceding claims, wherein the second resistivity (Rc) is lower than the first resistivity (Rp) by at least a factor hundred.

14. The device according to any of the preceding claims, wherein the piezoelectric layer (2) comprises a piezoelectric polymer material, or a composite of polymer material with inorganic piezoelectric material.

15. A method of manufacturing a piezoelectric device (100), the method comprising
depositing a polymer electrode (P) forming a contiguous surface area at a bottom and/or top electrode of a piezoelectric stack disposed on a substrate (1), the piezoelectric stack comprising a piezoelectric layer (2) sandwiched between the bottom electrode (3) and top electrode (4) to form a piezoelectric transducer (10), wherein the polymer electrode (P) is formed of a polymer based conductive material (Mp) having a first resistivity (Rp); and
printing a conductive line structure (5), before or after depositing the polymer electrode (P), wherein the conductive line structure (5) forms an extended line contact (Lc) overlapping subarea parts of the contiguous surface area with contact areas (Ap) of the polymer electrode (P) along a respective length of one or more conductive lines (5a,5b,5c,5d) of the conductive line structure (5) overlapping the contact areas (Ap), wherein the conductive line structure (5) is formed of a conductive material (Mc) having a second resistivity (Rc) that is lower than the first resistivity (Rp) to help distribute an electrical field (E) over the polymer electrode (P) via the extended line contact (Lc) including adjacent areas of the polymer electrode (P) not covered by the conductive line structure (5); wherein the conductive line structure (5) comprises a busbar forming the extended line contact (Lc) by a length of the busbar extending at least partially around and contacting a circumference on different sides of the polymer electrode (P).

## Patentansprüche

1. Piezoelektrische Vorrichtung (100) umfassend
einen piezoelektrischen Stapel mit einer piezoelektrischen Schicht (2), die zwischen einer unteren Elektrode (3) und einer oberen Elektrode (4) angeordnet ist, um einen piezoelektrischen Wandler (10) zu bilden, wobei mindestens eine der unteren und oberen Elektroden (3, 4) eine Polymerelektrode (P) ist, die aus einem leitfähigen Material auf Polymerbasis (Mp) mit einem ersten spezifischen Widerstand (Rp) gebildet ist; und
eine leitfähige Leitungsstruktur (5), die einen verlängerten Leitungskontakt (Lc) mit Kontaktbereichen (Ap) der Polymerelektrode (P) entlang einer jeweiligen Länge einer oder mehrerer leitfähiger Leitungen (5a, 5b, 5c, 5d) der leitfähigen Leitungsstruktur (5) bildet, die die Kontaktbereiche (Ap) überlappen, wobei die leitfähige Leitungsstruktur (5) aus einem leitfähigen Material (Mc) mit einem zweiten spezifischen Widerstand (Rc) gebildet ist, der niedriger ist als der erste spezifische Widerstand (Rp), um die Verteilung eines elektrischen Feldes (E) über die Polymerelektrode (P) über den verlängerten Leitungskontakt (Lc) zu unterstützen;
**dadurch gekennzeichnet dass**
die leitfähige Leitungsstruktur (5) eine Sammelschiene aufweist, die den verlängerten Leitungskontakt (Lc) bildet, indem sich die Sammelschiene zumindest teilweise um einen Umfang an verschiedenen Seiten der Polymerelektrode (P) erstreckt und diesen berührt.

2. Vorrichtung nach dem vorstehenden Anspruch, wobei die die Kontaktbereiche (Ap) überlappende leitfähige Leitungsstruktur (5) einen miteinander verbundenen Satz leitfähiger Metallleitungen (5a, 5b, 5c, 5d) aufweist, wobei jede Leitung eine Leitungsbreite (W1) von weniger als einem halben Millimeter aufweist.

3. Vorrichtung nach einem der vorstehenden Ansprüche, wobei sich die Länge der Sammelschiene über mindestens fünfzig Prozent des Umfangs der Polymerelektrode (P) erstreckt.

4. Vorrichtung nach einem der vorstehenden Ansprüche, wobei die benachbarten Bereiche der Polymerelektrode (P) zwischen den leitfähigen Leitungen nicht von der leitfähigen Leitungsstruktur (5) bedeckt sind.

5. Vorrichtung nach den beiden vorstehenden Ansprüchen, wobei die leitfähige Leitungsstruktur (5) ein Gitter aus leitfähigen Leitungen (5b, 5c, 5d) aufweist, das innere Kontaktbereiche (Api) der Polymerelektrode (P) abdeckt, um die Verteilung des elektrischen Feldes (E) in benachbarte Bereiche der Polymerelektrode (P), einschließlich zwischen den leitfähigen Leitungen, zu unterstützen, wobei das Gitter aus leitfähigen Leitungen (5b, 5c, 5d) über die Sammelschiene miteinander verbunden ist.

6. Vorrichtung nach dem vorstehenden Anspruch, wobei eine die Sammelschiene bildende leitfähige Leitung (5a) äußere Kontaktbereiche (Apo) an einer Kante der Polymerelektrode (P) abdeckt.

7. Vorrichtung nach einem der vorstehenden Ansprüche, wobei die Polymerelektrode (P) von einem Gitter aus leitfähigen Leitungen (5b, 5c, 5d) mit einer ersten Leitungsbreite (Wl) bedeckt ist, wobei jede Leitung über eine Sicherungsleitung (5f) mit einer zweiten Leitungsbreite (Wf), die mindestens um den Faktor zwei kleiner ist als die erste Leitungsbreite (Wl), mit der Sammelschiene (5a) verbunden ist.

8. Vorrichtung nach einem der vorstehenden Ansprüche, wobei die piezoelektrische Vorrichtung (100) eine dielektrische Barriere (6) aufweist, die durch ein Muster aus dielektrischem Material (Md) gebildet ist, das zwischen der leitfähigen Leitungsstruktur (5) auf einer Seite der piezoelektrischen Schicht (2) und einer gegenüberliegenden Elektrode auf der anderen Seite der piezoelektrischen Schicht (2) angeordnet ist.

9. Vorrichtung nach dem vorstehenden Anspruch, wobei die dielektrische Barriere (6) auf der piezoelektrischen Schicht (2) angeordnet ist, wobei das Muster aus dielektrischem Material (Md) über der leitfähigen Leitungsstruktur (5) angeordnet ist und sich die piezoelektrische Schicht (2) zwischen der dielektrischen Barriere (6) und der leitfähigen Leitungsstruktur (5) befindet, um zu verhindern, dass leitfähiges Material der oberen Elektrode (4) mit der piezoelektrischen Schicht (2) über der leitfähigen Leitungsstruktur (5) in Kontakt kommt.

10. Vorrichtung nach einem der beiden vorstehenden Ansprüche, wobei die dielektrische Barriere (6) zwischen der leitfähigen Leitungsstruktur (5) und der piezoelektrischen Schicht (2) angeordnet ist, wobei die leitfähige Leitungsstruktur (5) auf der Polymerelektrode (P) angeordnet ist.

11. Vorrichtung nach einem der vorstehenden Ansprüche, mit Polymerelektroden (P) sowohl als untere Elektrode (3) als auch als obere Elektrode (4), wobei die untere Elektrode (3) über eine erste Leiterbahnstruktur (5s) und die obere Elektrode (4) über eine zweite Leiterbahnstruktur (5t) verfügt, wobei die Leiterbahnen, die die zweite Leiterbahnstruktur (5t) bilden, gegenüber den Leiterbahnen, die die erste Leiterbahnstruktur (5s) bilden, versetzt angeordnet sind.

12. Vorrichtung nach einem der vorstehenden Ansprüche, wobei die Polymerelektrode (P) durch eine Schicht aus einem leitfähigen Material auf Polymerbasis (Mp) mit einer Dicke von weniger als einem Mikrometer gebildet ist, die die piezoelektrische Schicht (2) über eine Gesamtfläche von mindestens zwei Quadratzentimetern berührt.

13. Vorrichtung nach einem der vorstehenden Ansprüche, wobei der zweite spezifische Widerstand (Rc) um mindestens den Faktor hundert niedriger ist als der erste spezifische Widerstand (Rp).

14. Vorrichtung nach einem der vorstehenden Ansprüche, wobei die piezoelektrische Schicht (2) ein piezoelektrisches Polymermaterial oder einen Verbundwerkstoff aus Polymermaterial und anorganischem piezoelektrischem Material aufweist.

15. Verfahren zur Herstellung einer piezoelektrischen Vorrichtung (100), wobei das Verfahren Folgendes umfasst:
Aufbringen einer Polymerelektrode (P), die eine zusammenhängende Oberfläche an einer unteren und/oder oberen Elektrode eines piezoelektrischen Stapels bildet, der auf einem Substrat (1) angeordnet ist, wobei der piezoelektrische Stapel eine piezoelektrische Schicht (2) aufweist, die zwischen der unteren Elektrode (3) und der oberen Elektrode (4) angeordnet ist, um einen piezoelektrischen Wandler (10) zu bilden, wobei die Polymerelektrode (P) aus einem leitfähigen Material auf Polymerbasis (Mp) mit einem ersten spezifischen Widerstand (Rp) gebildet ist; und
Drucken einer leitfähigen Leitungsstruktur (5) vor oder nach dem Aufbringen der Polymerelektrode (P), wobei die leitfähige Leitungsstruktur (5) einen verlängerten Leitungskontakt (Lc) bildet, der Teilbereiche der angrenzenden Oberfläche mit Kontaktbereichen (Ap) der Polymerelektrode (P) entlang einer jeweiligen Länge einer oder mehrerer leitfähiger Leitungen (5a, 5b, 5c, 5d) der leitfähigen Leitungsstruktur (5) überlappt, die die Kontaktbereiche überlappen (Ap), wobei die leitfähige Leitungsstruktur (5) aus einem leitfähigen Material (Mc) mit einem zweiten spezifischen Widerstand (Rc) gebildet ist, der niedriger ist als der erste spezifische Widerstand (Rp), um die Verteilung eines elektrischen Feldes (E) über die Polymerelektrode (P) über den erweiterten Leitungskontakt (Lc) zu unterstützen, einschließlich benachbarter Bereiche der Polymerelektrode (P), die nicht von der leitfähigen Leitungsstruktur (5) bedeckt sind; wobei die leitfähige Leitungsstruktur (5) eine Sammelschiene aufweist, die den verlängerten Leitungskontakt (Lc) bildet, indem sich die Sammelschiene zumindest teilweise um einen Umfang auf verschiedenen Seiten der Polymerelektrode (P) erstreckt und diesen berührt.

## Revendications

1. Dispositif piézoélectrique (100) comprenant
une pile piézoélectrique avec une couche piézoélectrique (2) prise en sandwich entre une électrode inférieure (3) et une électrode supérieure (4) afin de former un transducteur piézoélectrique (10), dans lequel au moins l'une des électrodes inférieure et supérieure (3, 4) est une électrode polymère (P) formée d'un matériau conducteur à base de polymère (Mp) ayant une première résistivité (Rp) ; et
une structure de lignes conductrices (5) qui forme un contact de lignes étendu (Lc) avec des zones de contact (Ap) de l'électrode polymère (P) le long d'une longueur respective d'une ou plusieurs lignes conductrices (5a, 5b, 5c, 5d) de la structure de lignes conductrices (5) qui chevauche les zones de contact (Ap),
dans lequel la structure de lignes conductrices (5) est formée d'un matériau conducteur (Mc) ayant une deuxième résistivité (Rc) qui est inférieure à la première résistivité (Rp) afin de faciliter la distribution d'un champ électrique (E) sur l'électrode polymère (P) via le contact de lignes étendu (Lc) ;
**caractérisé en ce que**
la structure de lignes conductrices (5) comprend une barre de bus qui forme le contact de lignes étendu (Lc) par une longueur de la barre de bus qui s'étend au moins partiellement autour de et est en contact avec une circonférence sur différents côtés de l'électrode polymère (P).

2. Dispositif selon la revendication précédente, dans lequel la structure de lignes conductrices (5) qui chevauche les zones de contact (Ap) comprend un ensemble interconnecté de lignes métalliques conductrices (5a, 5b, 5c, 5d), chaque ligne ayant une largeur de lignes (WI) inférieure à la moitié d'un millimètre.

3. Dispositif selon l'une quelconque des revendications précédentes, dans lequel la longueur de la barre de bus s'étend le long d'au moins cinquante pourcents de la circonférence de l'électrode polymère (P).

4. Dispositif selon l'une quelconque des revendications précédentes, dans lequel les zones adjacentes de l'électrode polymère (P) entre les lignes conductrices ne sont pas recouvertes par la structure de lignes conductrices (5).

5. Dispositif selon les deux revendications précédentes, dans lequel la structure de lignes conductrices (5) comprend un réseau de lignes conductrices (5b, 5c, 5d) qui recouvre les zones de contact internes (Api) de l'électrode polymère (P), afin de faciliter la distribution du champ électrique (E) dans les zones adjacentes de l'électrode polymère (P), y compris entre les lignes conductrices, dans lequel le réseau de lignes conductrices (5b, 5c, 5d) est interconnecté via la barre de bus.

6. Dispositif selon la revendication précédente, dans lequel une ligne conductrice (5a), qui forme la barre de bus, recouvre les zones de contact externes (Apo) au niveau d'un bord de l'électrode polymère (P).

7. Dispositif selon l'une quelconque des revendications précédentes, dans lequel l'électrode polymère (P) est recouverte par un réseau de lignes conductrices (5b, 5c, 5d) ayant une première largeur de lignes (WI), dans lequel chaque ligne est reliée à la barre de bus (5a) via une ligne de fusibles (5f) ayant une deuxième largeur de lignes (Wf) qui est inférieure à la première largeur de lignes (WI) selon au moins un facteur de deux.

8. Dispositif selon l'une quelconque des revendications précédentes, dans lequel le dispositif piézoélectrique (100) comprend une barrière diélectrique (6) formée par un motif de matériau diélectrique (Md) disposé entre la structure de lignes conductrices (5) sur un côté de la couche piézoélectrique (2), et une électrode opposée sur l'autre côté de la couche piézoélectrique (2).

9. Dispositif selon la revendication précédente, dans lequel la barrière diélectrique (6) est disposée sur le dessus de la couche piézoélectrique (2), dans lequel le motif de matériau diélectrique (Md) est disposé au-dessus de la structure de lignes conductrices (5) avec la couche piézoélectrique (2) entre la barrière diélectrique (6) et la structure de lignes conductrices (5), afin d'empêcher tout matériau conducteur de l'électrode supérieure (4) d'entrer en contact avec la couche piézoélectrique (2) au-dessus de la structure de lignes conductrices (5).

10. Dispositif selon l'une quelconque des deux revendications précédentes, dans lequel la barrière diélectrique (6) est disposée entre la structure de lignes conductrices (5) et la couche piézoélectrique (2), dans lequel la structure de lignes conductrices (5) est disposée sur le dessus de l'électrode polymère (P).

11. Dispositif selon l'une quelconque des revendications précédentes, comprenant des électrodes polymère (P) en guise d'électrode inférieure (3) et d'électrode supérieure (4), dans lequel l'électrode inférieure (3) est équipée d'une première structure de lignes conductrices (5s) et l'électrode supérieure (4) est équipée d'une deuxième structure de lignes conductrices (5t), dans lequel les lignes conductrices qui forment la deuxième structure de lignes conductrices (5t) sont décalées par rapport aux lignes conductrices qui forment la première structure de lignes conductrices (5s).

12. Dispositif selon l'une quelconque des revendications précédentes, dans lequel l'électrode polymère (P) est formée par une couche de matériau conducteur à base de polymère (Mp) ayant une épaisseur inférieure à un micromètre en contact avec la couche piézoélectrique (2) sur une surface totale d'au moins deux centimètres carrés.

13. Dispositif selon l'une quelconque des revendications précédentes, dans lequel la deuxième résistivité (Rc) est inférieure à la première résistivité (Rp) selon au moins un facteur de cent.

14. Dispositif selon l'une quelconque des revendications précédentes, dans lequel la couche piézoélectrique (2) comprend un matériau polymère piézoélectrique, ou un composite de matériau polymère avec un matériau piézoélectrique inorganique.

15. Procédé de fabrication d'un dispositif piézoélectrique (100), le procédé comprenant
le dépôt d'une électrode polymère (P) qui forme une surface contiguë au niveau d'une électrode inférieure et/ou supérieure d'une pile piézoélectrique disposée sur un substrat (1), la pile piézoélectrique comprenant une couche piézoélectrique (2) prise en sandwich entre l'électrode inférieure (3) et l'électrode supérieure (4) afin de former un transducteur piézoélectrique (10), dans lequel l'électrode polymère (P) est formée d'un matériau conducteur à base de polymère (Mp) ayant une première résistivité (Rp) ; et
l'impression d'une structure de lignes conductrices (5), avant ou après le dépôt de l'électrode polymère (P), dans lequel la structure de lignes conductrices (5) forme un contact de lignes étendu (Lc) qui chevauche les parties de sous-surface de la surface contiguë avec les zones de contact (Ap) de l'électrode polymère (P) le long d'une longueur respective d'une ou plusieurs lignes conductrices (5a, 5b, 5c, 5d) de la structure de lignes conductrices (5) qui chevauche les zones de contact (Ap), dans lequel la structure de lignes conductrices (5) est formée d'un matériau conducteur (Mc) ayant une deuxième résistivité (Rc) qui est inférieure à la première résistivité (Rp) afin de faciliter la distribution d'un champ électrique (E) sur l'électrode polymère (P) via le contact de lignes étendu (Lc), y compris les zones adjacentes de l'électrode polymère (P) non recouvertes par la structure de lignes conductrices (5) ; dans lequel la structure de lignes conductrices (5) comprend une barre de bus qui forme le contact de lignes étendu (Lc) par une longueur de la barre de bus qui s'étend au moins partiellement autour de et est en contact avec une circonférence sur différents côtés de l'électrode polymère (P).
